# EUROPEAN PATENT APPLICATION

(11) **EP 2 830 105 A1**
(43) Date of publication of application: **28.01.2015**
(21) Application number: 14178139.3
(22) Date of filing: 23.07.2014
(51) Int. Cl.: H01L 33/22, H01L 33/42

(54) **Light emitting diode and manufacturing method thereof**

(30) Priority: 26.07.2013 TW 102126941
(71) Applicant: Lextar Electronics Corp., 30075 Hsinchu (TW)
(72) Inventor: Chen, Cheng-Hung, 300 Hsinchu City (TW)
(74) Representative: Winter, Brandl, Fürniss, Hübner, Röss, Kaiser, Polte - Partnerschaft mbB

(57) **Abstract**

A light emitting diode includes a semiconductor epitaxial stack structure (200), a first transparent conductive layer (300) and at least one second transparent conductive layer (400). The semiconductor epitaxial stack structure (200) includes a first semiconductor layer (210), an active layer (220) and a second semiconductor layer (230). The active layer (220) is disposed on a portion of the second semiconductor layer (230). The first semiconductor layer (210) is disposed on the active layer (220). The first transparent conductive layer (300) is disposed on the first semiconductor layer (210), and includes plural first crystalline particles (310), wherein the average size thereof is d1. The second transparent conductive layer (400) is disposed on the first transparent conductive layer (300), and includes plural second crystalline particles (410), wherein the average size thereof is d2, and d1 is greater than d2.

## Description

### BACKGROUND

### Technical Field

Embodiments of the present invention relate to a light emitting diode. More particularly, embodiments of the present invention relate to a light emitting diode and the manufacturing method thereof.

### Description of Related Art

Because the light emitting diode has the advantages of low power consumption and small volume, it becomes one of the popular illumination devices recently. A conventional light emitting diode includes an N-type semiconductor layer, an active layer and a P-type semiconductor layer which are stacked in sequence. The N-type semiconductor layer and the P-type semiconductor layer have a metal electrode thereon respectively.

In a conventional light emitting diode, a transparent conductive layer is disposed between the P-type semiconductor layer and the metal electrode. The transparent conductive layer may be annealed to decrease the contact resistance between the transparent conductive layer and the P-type semiconductor layer so that the driving voltage of the light emitting diode is decreased.

However, the sheet resistance of the transparent conductive layer may be significantly increased after annealed, while the lateral diffusion of the electrical current is impeded.

### SUMMARY

One aspect of this invention is providing a light emitting diode in which the sheet resistance of the transparent conductive layer may be decreased effectively such that the diffusion of the electrical current is improved.

According to one embodiment of this invention, a light emitting diode includes a semiconductor epitaxial stack structure, a first transparent conductive layer and at least one second transparent conductive layer. The semiconductor epitaxial stack structure includes a first semiconductor layer, an active layer and a second semiconductor layer. The active layer is disposed on portion of the second semiconductor layer. The first semiconductor layer is disposed on the active layer. The first transparent conductive layer is disposed on the first semiconductor layer, and includes plural first crystalline particles, wherein the average size thereof is d1. The second transparent conductive layer is disposed on the first transparent conductive layer, and includes plural second crystalline particles, wherein the average size thereof is d2, and d1 is greater than d2.

Another aspect of this invention is providing a manufacturing method of a light emitting diode. The method includes the steps of: providing a substrate, and forming a semiconductor epitaxial stack structure on the substrate. The semiconductor epitaxial stack structure includes a first semiconductor layer, an active layer and a second semiconductor layer. The active layer is disposed on a portion of the second semiconductor layer. The first semiconductor layer is disposed on the active layer. Then, a first transparent conductive layer is formed on the first semiconductor layer and includes plural first crystalline particles, wherein the average size thereof is d1'. An annealing process is performed so that the average size d1' of the first crystalline particles become d1, wherein d1>d1'. A second transparent conductive layer is formed on the first transparent conductive layer. The second transparent conductive layer includes plural second crystalline particles, wherein the average size thereof is d2, and d1 is greater than d2.

In foregoing embodiments, the annealed first transparent conductive layer and the un-annealed second transparent conductive layer are disposed on the first semiconductor layer. Because an equivalent parallel circuit is formed by the first transparent conductive layer and the second transparent conductive layer, the equivalent sheet resistance of the first transparent conductive layer and the second transparent conductive layer is significantly decreased such that the current diffusion is improved.

### BRIEF DESCRIPTION OF THE DRAWINGS

The invention can be more fully understood by reading the following detailed description of the embodiment, with reference made to the accompanying drawings as follows:
Fig. 1 is a cross-sectional view of a light emitting diode according to one embodiment of this invention;
Fig. 2 is a cross-sectional view of a light emitting diode according to another embodiment of this invention;
Fig. 3 is a cross-sectional view of a light emitting diode according to further another embodiment of this invention;
Fig. 4A to Fig. 4F are cross-sectional views for the steps of the manufacturing method of the light emitting diode according to one embodiment of this invention;
Fig. 5A to Fig. 5G are cross-sectional views for the steps of the manufacturing method of the light emitting diode according to another embodiment of this invention; and
Fig. 6A to Fig. 6G are cross-sectional views for the steps of the manufacturing method of the light emitting diode according to further another embodiment of this invention.

### DETAILED DESCRIPTION

Reference will now be made in detail to the present embodiments of the invention, examples of which are illustrated in the accompanying drawings. To clarify this invention, some details for practice may be described in some embodiments. However, the person skilled in the art should understand these details may be not necessary for some other embodiments such that they should not to limit this invention. To simplify the drawings, some conventional structures and devices are illustrated simply. Wherever possible, the same reference numbers are used in the drawings and the description to refer to the same or like parts.

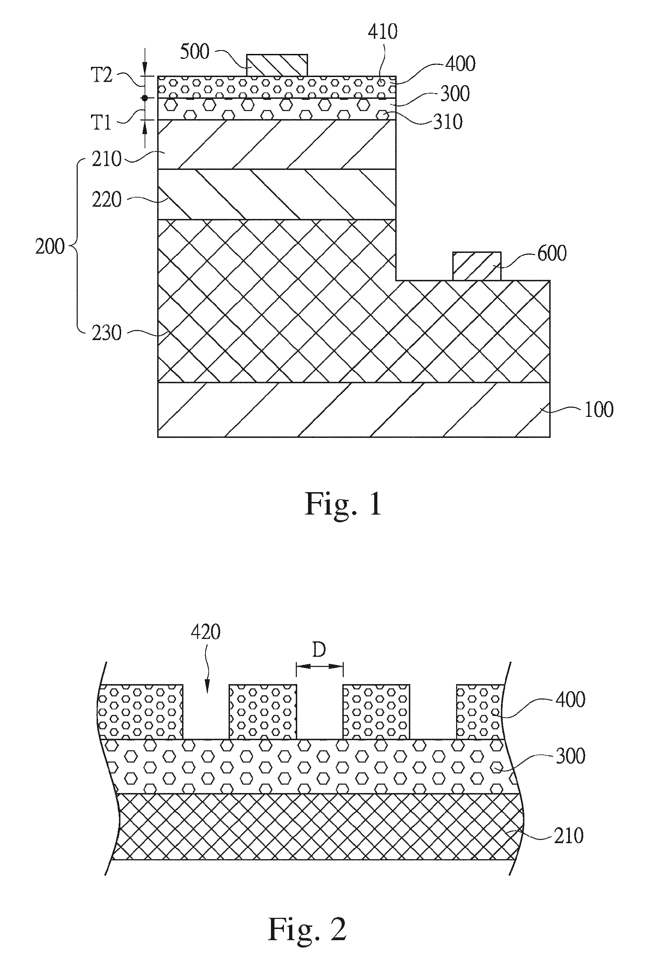

Fig. 1 is a cross-sectional view of a light emitting diode according to one embodiment of this invention. As shown in Fig.1, in this embodiment, a light emitting diode may include a substrate 100, a semiconductor epitaxial stack structure 200, a first transparent conductive layer 300, at least one second transparent conductive layer 400, a first electrode 500 and a second electrode 600. The semiconductor epitaxial stack structure 200 includes a first semiconductor layer 210, an active layer 220 and a second semiconductor layer 230. The second semiconductor layer 230 is disposed on the substrate 100. The active layer 220 is disposed on portion of the second semiconductor layer 230. The first semiconductor layer 210 is disposed on the active layer 220. The first transparent conductive layer 300 is disposed on the first semiconductor layer 210. The second transparent conductive layer 400 is disposed on the first transparent conductive layer 300. In other words, the first transparent conductive layer 300 is disposed between the second transparent conductive layer 400 and the first semiconductor layer 210. The first electrode 500 is disposed on the second transparent conductive layer 400. The second electrode 600 is disposed on a portion of the second semiconductor layer 230 which is not covered by the active layer 220 and the first semiconductor layer 210.

In this embodiment, the first transparent conductive layer 300 is annealed, while the second transparent conductive layer 400 is not annealed. It is observed by measuring an equivalent parallel circuit that is formed by the annealed first transparent conductive layer 300 and the un-annealed second transparent conductive layer 400. That is, the equivalent sheet resistance of the first transparent conductive layer 300 and the second transparent conductive layer 400 is less than which of the first transparent conductive layer 300 or the second transparent conductive layer 400 respectively. Accordingly, when the first transparent conductive layer 300 and the second transparent conductive layer 400 are disposed between the first semiconductor layer 210 and the first electrode 500, the lateral current diffusion is improved.

For the light emitting diode, the more uniform the current diffusion is, the lower the driving voltage is. In order to prove that the first transparent conductive layer 300 and the second transparent conductive layer 400 are able to improve the current diffusion, the driving voltages obtained by an experiment are listed in the following table for comparison. The following table is a table for comparing the driving voltage of a conventional LED with the driving voltage of the LED according to the embodiment above.

| The distance between the first electrode and the second electrode (micrometer) | The driving voltage of a conventional LED (Volt.) | The driving voltage of the LED according to this embodiment (Volt.) |
|---|---|---|
| 200 | 3.16 | 3.08 |
| 140 | 3.20 | 3.10 |
| 100 | 3.25 | 3.15 |

As shown in the table above, no matter how far the distance between the first electrode 500 and the second electrode 600 is, the driving voltage of the LED according to this embodiment is less than which of a conventional LED. Therefore, it is proved that the cooperation of the first transparent conductive layer 300 and the second transparent conductive layer 400 improves the current diffusion.

Because the annealing treatment may increase the sheet resistance, the first sheet resistance R1 of the first transparent conductive layer 300 is greater than the second resistance R2 of the second transparent conductive layer 400.

The ratio of R1/R2 is preferably between 2 and 10, that is, 2≦ R1/R2≦ 10. In other words, the first sheet resistance R1 is at least twice as much as the second resistance R2.

The first transparent conductive layer 300 includes plural first crystalline particles 310, wherein the average diameter of the first crystalline particles 310 (grain size) is d1. The second transparent conductive layer 400 includes plural second crystalline particles 410. The average diameter of the second crystalline particles 410 (grain size) is d2. The annealing treatment makes the smaller crystalline particles cohered to form a larger crystalline particle. Therefore, the average diameter d1 of the first crystalline particles 310 with annealing is greater than the average diameter d2 of the second crystalline particles 410 without annealing. It is understood that the average diameter d1 of the first crystalline particles 310 refers to the average of the diameters of all first crystalline particles 310. Similarly, the average diameter d2 of the second crystalline particles 410 refers to the average of the diameters of all second crystalline particles 410. Preferably, the diameter of any first crystalline particle 310 is greater than which of the largest one of the second crystalline particles 410.

The annealing treatment may not only change the sheet resistance and the grain size, but also change the transparency. In more detail, during the annealing of the first transparent conductive layer 300, the oxygen may penetrate into the first transparent conductive layer 300 so that the transparency of the first transparent conductive layer 300 is increased. Therefore, in some embodiments, the first transparent conductive layer 300 has a first thickness T1, the second transparent conductive layer 400 has a second thickness T2, and the first thickness T1 is greater than or equal to the second thickness T2 so that the transmittance of light is improved. In other words, the first thickness T1 of the first transparent conductive layer 300 with high transparency is greater than or equal to the second thickness T2 of the second transparent conductive layer 400 with low transparency such that thetransmittance of light is improved.

In this embodiment, the first semiconductor layer 210 may be a P-type semiconductor layer, while the second semiconductor layer 230 may be an N-type semiconductor layer. For example, the first semiconductor layer 210 may be formed of a semiconductor nitride doped with P-type impurities (e.g. P-GaN). It may be formed by doping impurities of elements of Group II (e.g. Mg) into a Gallium nitride crystal. The second semiconductor layer 230 may be formed of a semiconductor nitride doped with N-type impurities (e.g. N-GaN). It may be formed by doping impurities of elements of Group IV (e.g. Si) into a Gallium nitride crystal. In this embodiment, the active layer 220 may include plural quantum well structures which help the combination of electrons and electron holes provided by the first semiconductor layer 210 and the second semiconductor layer 230.

In other embodiments, the first semiconductor layer 210 may be an N-type semiconductor layer, while the second semiconductor layer 230 may be a P-type semiconductor layer. For example, the first semiconductor layer 210 may be formed of a semiconductor nitride doped with N-type impurities (e.g. N-GaN). It may be formed by doping impurities of elements of Group IV (e.g. Si) into a Gallium nitride crystal. The second semiconductor layer 230 may be formed of a semiconductor nitride doped with P-type impurities (e.g. P-GaN). It may be formed by doping impurities of elements of Group II (e.g. Mg) into a Gallium nitride crystal.

In this embodiment, the first transparent conductive layer 300 and the second transparent conductive layer 400 may be, but are not limited to be, Indium Tin Oxide films (ITO) or Indium Zinc Oxide films (IZO). In this embodiment, the substrate 100 may be, but is not limited to be, a sapphire substrate.

Fig. 2 is a cross-sectional view of a light emitting diode according to another embodiment of this invention. As shown in Fig. 2, the major difference between this embodiment and the embodiment in Fig.1 is that the second transparent conductive layer 400 of this embodiment has plural openings 420. These openings 420 may expose the first transparent conductive layer 300 so that portion of light may go through the first transparent conductive layer 300 to the environment directly and not need to go into the second transparent conductive layer 400. Accordingly, the illuminating effect of the LED is improved. In some embodiments, the openings 420 have a diameter D and the diameter D preferably is between 0.5 micron and 500 micron. Thus, the illuminating effect is improved without affecting the sheet resistance.

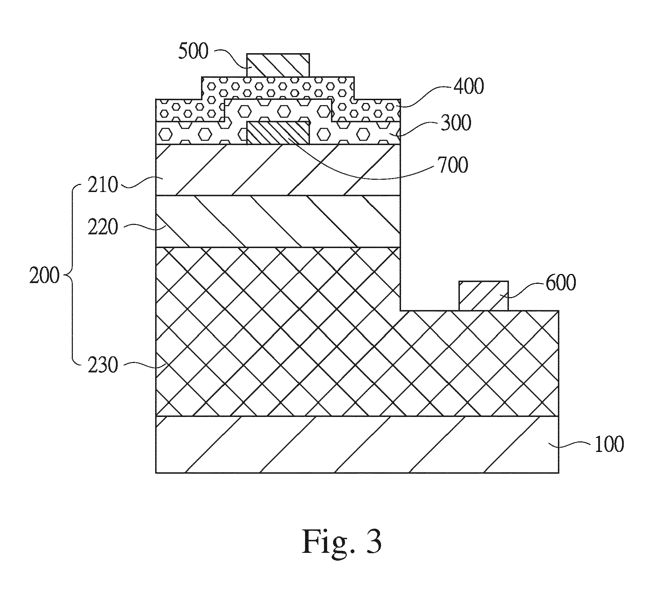

Fig. 3 is a cross-sectional view of a light emitting diode according to another embodiment of this invention. As shown in Fig. 3, the major difference between this embodiment and the embodiment in Fig.1 is that the LED of this embodiment further includes a current block layer 700. The current block layer 700 is disposed on portion surface of the first semiconductor layer 210. In more detail, the current block layer 700 and the first transparent conductive layer 300 are disposed on the same surface of the first semiconductor layer 210, and the current block layer 700 is covered by the first transparent conductive layer 300. The projection of the first electrode 500 on the first semiconductor layer 210 overlaps at least portion of the current block layer 700. In other words, the current block layer 700 is located exactly below the first electrode 500. The current block layer 700 is made of an isolation material (e.g. silicon oxide, SiO₂ so that the current from the first electrode 500 may be prevented from directly flowing down into the first semiconductor layer 210, and therefore, the current can be first forced to diffuse laterally in the first transparent conductive layer 300 more uniformly, and then to flow into the first semiconductor layer 210.

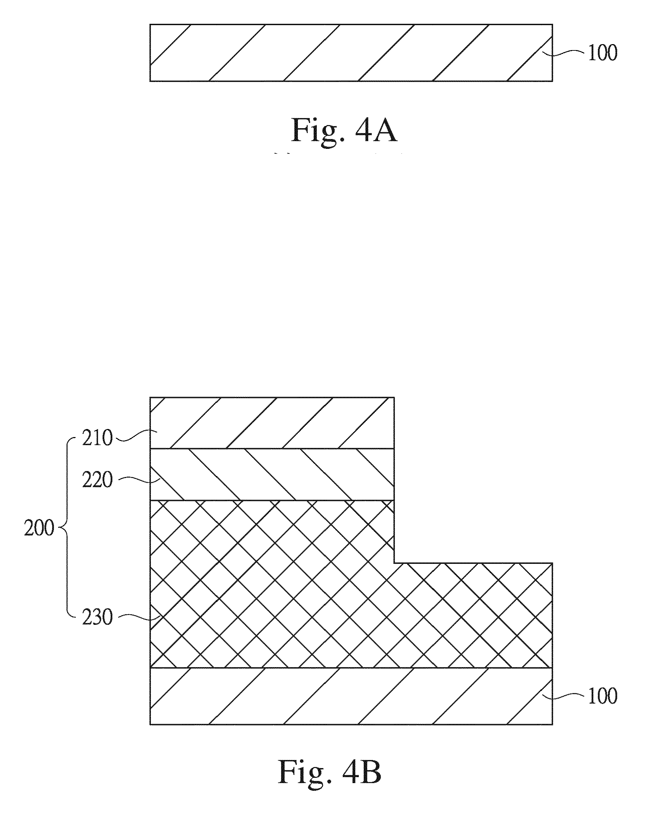

Fig. 4A to Fig. 4F are cross-sectional views for the steps of the manufacturing method of the light emitting diode according to one embodiment of this invention. In Fig. 4A, the substrate 100 is provided. The substrate 100 may be, but is not limited to be, a sapphire substrate.

In Fig. 4B, the semiconductor epitaxial stack structure 200 is formed on the substrate 100. The semiconductor epitaxial stack structure 200 includes a second semiconductor layer 230, an active layer 220 and a first semiconductor layer 210. These three layers are stacked on the substrate 100 from the bottom to the top in sequence. In practice, the second semiconductor layer 230 is disposed on the substrate 100, the active layer 220 is disposed on portion of the second semiconductor layer 230 and the first semiconductor layer 210 is disposed on the active layer 220.

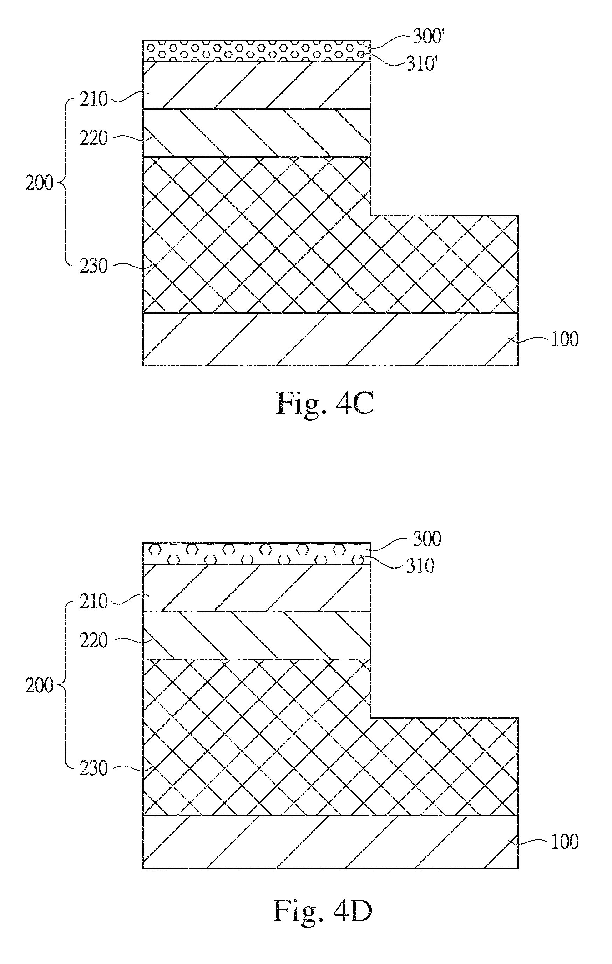

In Fig. 4C, a first transparent conductive layer 300' is disposed on the first semiconductor layer 210. The first transparent conductive layer 300' includes plural first crystalline particles 310', in which the average diameter of the first crystalline particles 310 (grain size) is d1'. For example, the manufacturer may deposit a transparent conductive material on the first semiconductor layer 210 by evaporation deposition or sputtering to form the first transparent conductive layer 300'.

In Fig. 4D, an annealing treatment is performed on the first transparent conductive layer 300' to form the first transparent conductive layer 300. After the annealing process, the average diameter of the first crystalline particles 310 becomes d1. Because the annealing treatment makes the smaller crystalline particles to form a larger crystalline particle, d1 is greater than d1'. Preferably, the temperature of the annealing treatment is not less than 200 degrees centigrade and not greater than 700 degrees centigrade. More preferably, the temperature of the annealing treatment is not less than 400 degrees centigrade and not greater than 550 degrees centigrade.

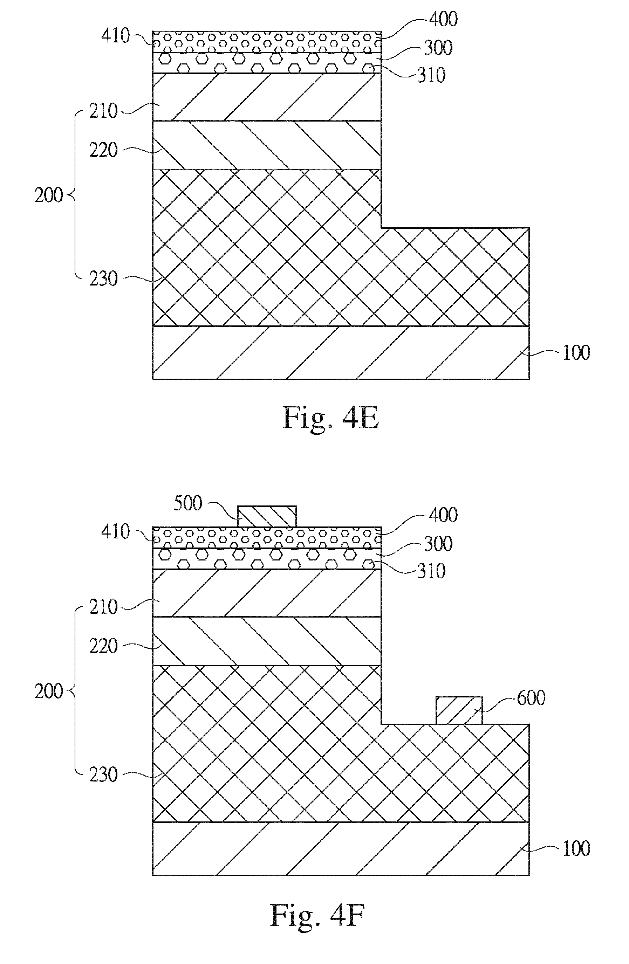

In Fig. 4E, the second transparent conductive layer 400 is formed on the first transparent conductive layer 300. For example, the manufacturer may deposit a transparent conductive material on the first transparent conductive layer 300 by evaporation deposition or sputtering to form the second transparent conductive layer 400. The second transparent conductive layer 400 includes plural second crystalline particles 410, in which the average diameter of the second crystalline particles 410 (grain size) is d2. Because the second transparent conductive layer 400 is not annealed, d1 is greater than d2.

In Fig. 4F, a first electrode 500 is formed on the second transparent conductive layer 400, and the second electrode 600 is formed on a portion the second semiconductor layer 230 where is not covered by the active layer 220 and the first semiconductor layer 210. Accordingly, the light emitting diode is accomplished.

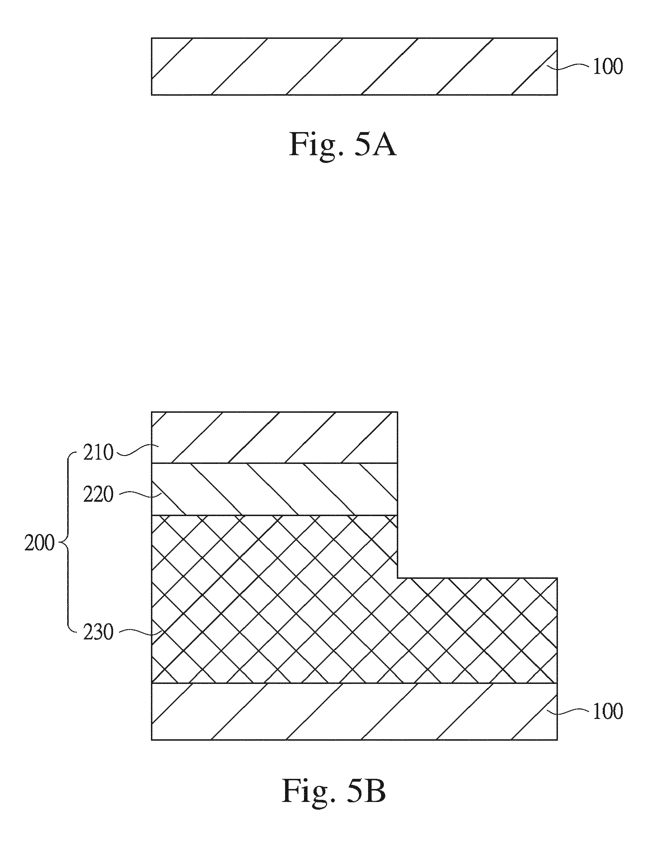

Fig. 5A to Fig. 5G are cross-sectional views for the steps of the manufacturing method of the light emitting diode according to another embodiment of this invention. In Fig. 5A, the substrate 100 is provided. The substrate 100 may be, but is not limited to be, a sapphire substrate.

In Fig. 5B, the semiconductor epitaxial stack structure 200 is formed on the substrate 100. The semiconductor epitaxial stack structure 200 includes a second semiconductor layer 230, an active layer 220 and a first semiconductor layer 210. These three layers are stacked on the substrate 100 from the bottom to the top in sequence. In practice, the second semiconductor layer 230 is disposed on the substrate 100, the active layer 220 is disposed on portion of the second semiconductor layer 230 and the first semiconductor layer 210 is disposed on the active layer 220.

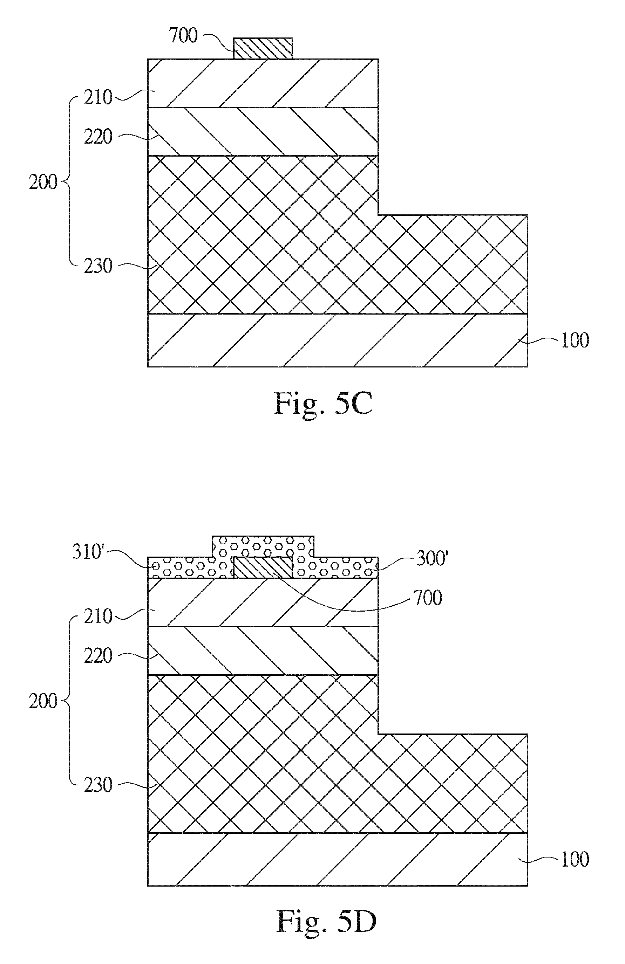

In Fig. 5C, a current block layer 700 may be formed on the surface of the first semiconductor layer 210. The current block layer 700 may be made of an isolation material.

In Fig. 5D, a first transparent conductive layer 300' is disposed on the first semiconductor layer 210 and the current block layer 700. The first transparent conductive layer 300' includes plural first crystalline particles 310',in which the average diameter of the first crystalline particles 310 (grain size) is d1'. For example, the manufacturer may deposit a transparent conductive material on the first semiconductor layer 210 by evaporation deposition or sputtering to form the first transparent conductive layer 300'.

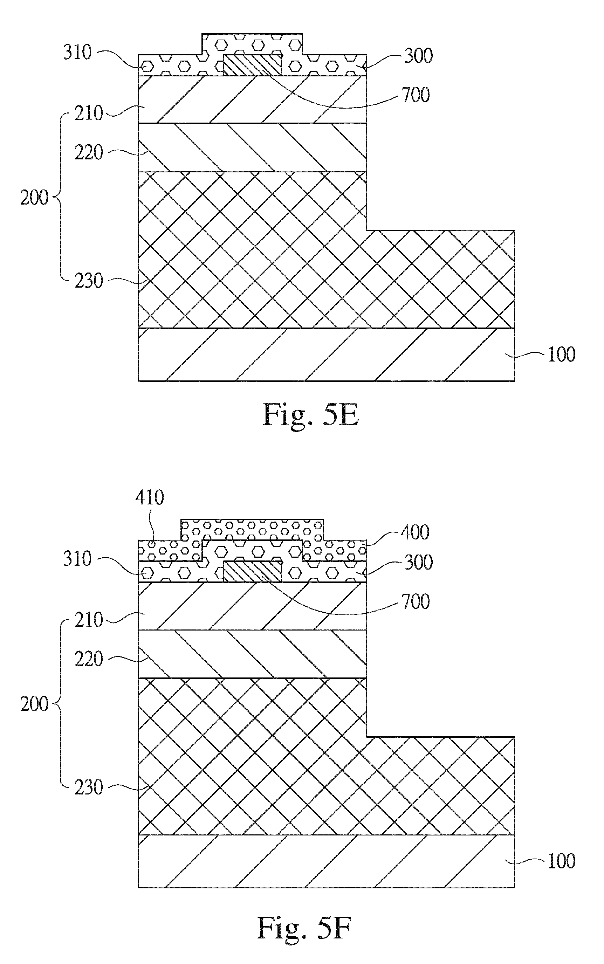

In Fig. 5E, an annealing treatment is performed on the first transparent conductive layer 300' to form the first transparent conductive layer 300. After the annealing process, the average diameter of the first crystalline particles 310 becomes d1. Because the annealing treatment makes the smaller crystalline particles to form a larger crystalline particle, d1 is greater than d1'. Preferably, the temperature of the annealing treatment is not less than 200 degrees centigrade and not greater than 700 degrees centigrade. More preferably, the temperature of the annealing treatment is not less than 400 degrees centigrade and not greater than 550 degrees centigrade.

In Fig. 5F, the second transparent conductive layer 400 is formed on the first transparent conductive layer 300. For example, the manufacturer may deposit a transparent conductive material on the first transparent conductive layer 300 by evaporation deposition or sputtering to form the second transparent conductive layer 400. The second transparent conductive layer 400 includes plural second crystalline particles 410, in which the average diameter of the second crystalline particles 410 (grain size) is d2. Because the second transparent conductive layer 400 is not annealed, d1 is greater than d2.

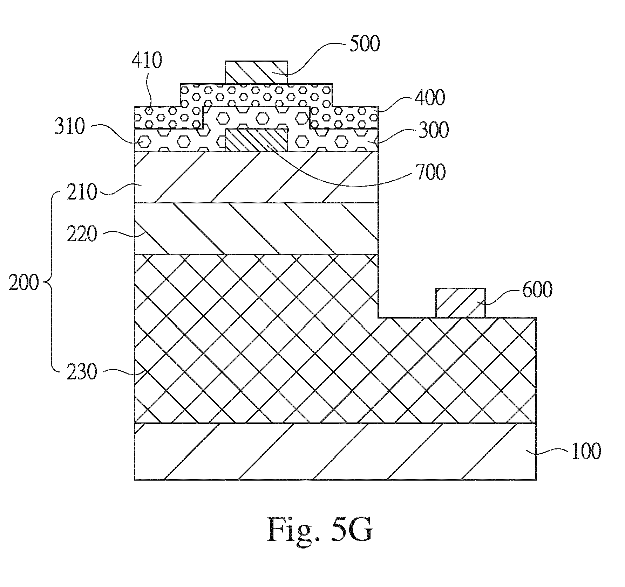

In Fig. 5G, a first electrode 500 is formed on the second transparent conductive layer 400, and the second electrode 600 is formed on a portion of the second semiconductor layer 230 where is not covered by the active layer 220 and the first semiconductor layer 210. Accordingly, the light emitting diode is accomplished.

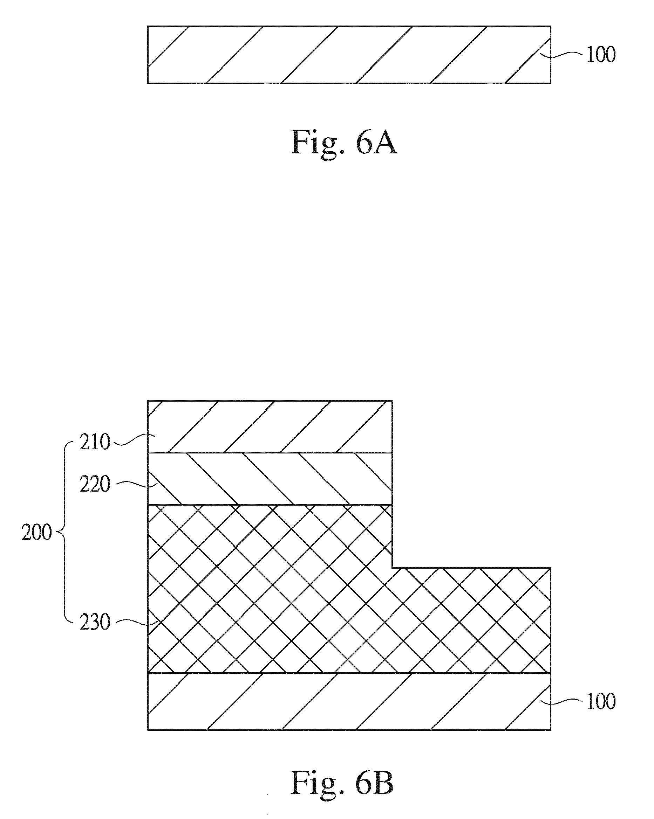

Fig. 6A to Fig. 6G are cross-sectional views for the steps of the manufacturing method of the light emitting diode according to further another embodiment of this invention. In Fig. 6A, the substrate 100 is provided. The substrate 100 may be, but is not limited to be, a sapphire substrate.

In Fig. 6B, the semiconductor epitaxial stack structure 200 is formed on the substrate 100. The semiconductor epitaxial stack structure 200 includes a second semiconductor layer 230, an active layer 220 and a first semiconductor layer 210. These three layers are stacked on the substrate 100 from the bottom to the top in sequence. In practice, the second semiconductor layer 230 is disposed on the substrate 100, the active layer 220 is disposed on portion of the second semiconductor layer 230 and the first semiconductor layer 210 is disposed on the active layer 220.

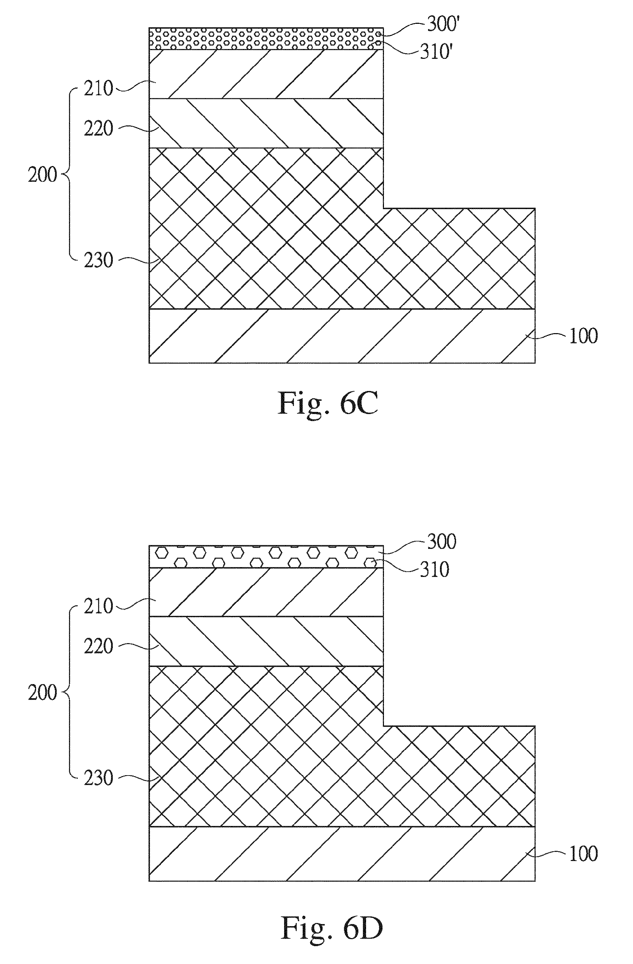

In Fig. 6C, a first transparent conductive layer 300' is disposed on the first semiconductor layer 210 and the current block layer 700. The first transparent conductive layer 300' includes plural first crystalline particles 310', in which the average diameter of the first crystalline particles 310 (grain size) is d1'. For example, the manufacturer may deposit a transparent conductive material on the first semiconductor layer 210 by evaporation deposition or sputtering to form the first transparent conductive layer 300'.

In Fig. 6D, an annealing treatment is performed on the first transparent conductive layer 300' to form the first transparent conductive layer 300. After the annealing process, the average diameter of the first crystalline particles 310 becomes d1. Because the annealing treatment makes the smaller crystalline particles integrated to a larger crystalline particle, d1 is greater than d1'. Preferably, the temperature of the annealing treatment is not less than 200 degrees centigrade and not greater than 700 degrees centigrade. More preferably, the temperature of the annealing treatment is not less than 400 degrees centigrade and not greater than 550 degrees centigrade.

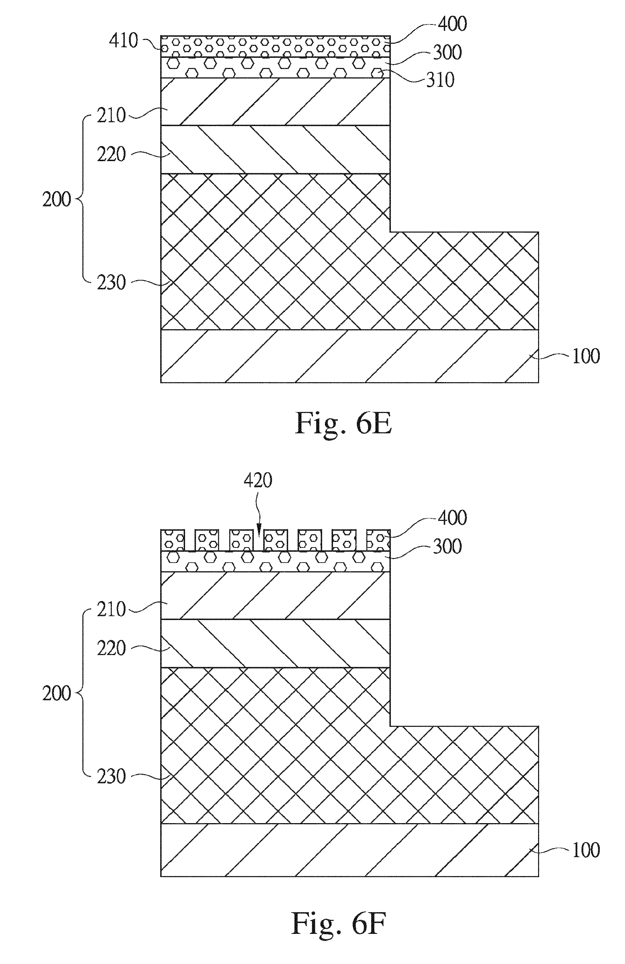

In Fig. 6E, the second transparent conductive layer 400 is formed on the first transparent conductive layer 300. For example, the manufacturer may deposit a transparent conductive material on the first transparent conductive layer 300 by evaporation deposition or sputtering to form the second transparent conductive layer 400. The second transparent conductive layer 400 includes plural second crystalline particles 410, in which the average diameter of the second crystalline particles 410 (grain size) is d2. Because the second transparent conductive layer 400 is not annealed, d1 is greater than d2.

In Fig. 6F, the second transparent conductive layer 400 may be etched to formed plural openings 420 which expose the first transparent conductive layer 300.

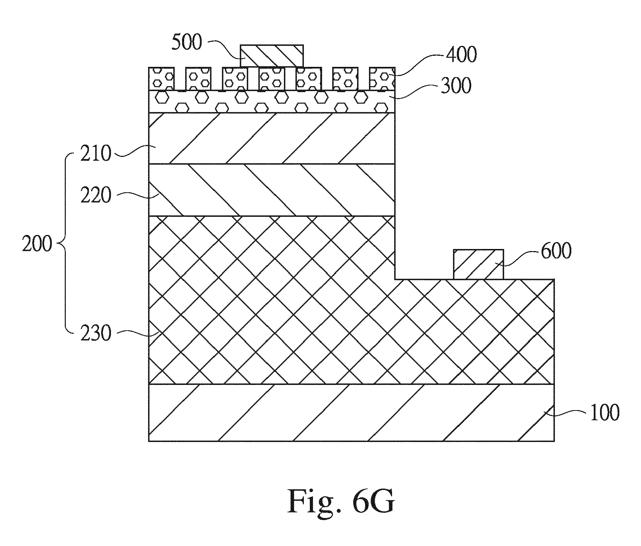

In Fig. 6G, a first electrode 500 is formed on the second transparent conductive layer 400, and the second electrode 600 is formed on a portion of the second semiconductor layer 230 where is not covered by the active layer 220 and the first semiconductor layer 210. Accordingly, the light emitting diode is accomplished.

## Claims

1. A light emitting diode, **characterized by** comprising:
a semiconductor epitaxial stack structure (200), having a first semiconductor layer (210), an active layer (220) and a second semiconductor layer (230), wherein the active layer (220) is disposed on a portion of the second semiconductor layer (230) and the first semiconductor layer (210) is disposed on the active layer (220);
a first transparent conductive layer (300), disposed on the first semiconductor layer (210), wherein the first transparent conductive layer (300) comprises a plurality of first crystalline particles (310), and wherein the average size thereof is d1; and
a second transparent conductive layer (400), disposed on the first transparent conductive layer (300), wherein the second transparent conductive layer (400) comprises a plurality of second crystalline particles (410), and wherein the average size thereof is d2, and d1 is greater than d2.

2. The light emitting diode of claim 1, **characterized in that** the first transparent conductive layer (300) has a first sheet resistance R1, the second transparent conductive layer (400) has a second sheet resistance R2, and the ratio of R1/R2 is between 2 and 10.

3. The light emitting diode of claim 1, **characterized in that** the size of any of the first crystalline particles (310) is greater than that of any of the second crystalline particles (410).

4. The light emitting diode of claim 1, **characterized in that** the second transparent conductive layer (400) has a plurality of openings (420) which expose the first transparent conductive layer (300).

5. The light emitting diode of claim 4, **characterized in that** each of the openings (420) has a diameter D, and 0.5 micron < D < 500 micron.

6. The light emitting diode of claim 1, **characterized by** further comprising:
a first electrode (500), disposed on the second transparent conductive layer (400); and
a second electrode (600), disposed on a portion of the second semiconductor layer (230) where is not covered by the active layer (220) and the first semiconductor layer (210).

7. The light emitting diode of claim 6, **characterized by** further comprising:
a current block layer (700), disposed on a portion of the first semiconductor layer (210), wherein the current block layer (700) is covered by the first transparent conductive layer (300), and wherein
the projection of the first electrode (500) on the first semiconductor layer (210) overlaps at least portion of the current block layer (700).

8. A manufacturing method of a light emitting diode, **characterized by** comprising:
providing a substrate (100);
forming a semiconductor epitaxial stack structure (200) on the substrate (100), wherein the semiconductor epitaxial stack structure (200) comprises a first semiconductor layer (210), an active layer (220) and a second semiconductor layer (230), wherein the active layer (220) is disposed on a portion of the second semiconductor layer (230) and the first semiconductor layer (210) is disposed on the active layer (220);
forming a first transparent conductive layer (300') on the first semiconductor layer (210), wherein the first transparent conductive layer (300') comprises a plurality of first crystalline particles (310'),
and wherein the average size thereof is d1';
performing an annealing process so that the average size d1' of the first crystalline particles (310') become d1, wherein d1>d1'; and
forming a second transparent conductive layer (400) on the first transparent conductive layer (300), wherein the second transparent conductive layer (400) comprises a plurality of second crystalline particles (410), and wherein the average size thereof is d2, and d1 is greater than d2.

9. The manufacturing method of a light emitting diode of claim 8, **characterized by** further comprising:
forming a first electrode (500) on the second transparent conductive layer (400); and
forming a second electrode (600) on a portion of the second semiconductor layer (230) where is not covered by the active layer (220) and the first semiconductor layer (210).

10. The manufacturing method of a light emitting diode of claim 9, **characterized in that** before forming the first transparent conductive layer (300') on the first semiconductor layer (210), the method further comprising:
forming a current block layer (700) on the first semiconductor layer (210), wherein the projection of the first electrode (500) on the first semiconductor layer (210) overlaps at least portion of the current block layer (700).

11. The manufacturing method of a light emitting diode of claim 8, **characterized in that** before forming a first electrode (500) on the second semiconductor layer (230), the method further comprising:
etching the second transparent conductive layer (400) to form a plurality of openings (420) to expose the first transparent conductive layer (300).

12. The manufacturing method of a light emitting diode of claim 8, **characterized in that** the temperature of annealing process is not less than 200 degrees centigrade and not greater than 700 degrees centigrade.

13. The manufacturing method of a light emitting diode of claim 8, **characterized in that** the first transparent conductive layer (300') and the second transparent conductive layer (400) are formed by evaporation deposition or sputtering.
